# EUROPEAN PATENT SPECIFICATION

(11) **EP 0 866 508 B1**
(45) Date of publication and mention of the grant of the patent: **11.06.2003**
(21) Application number: 98103987.8
(22) Date of filing: 06.03.1998
(51) Int. Cl.: H01L 39/24

(54) **Method of preparing rare earth-barium-cuprates superconductors**
Verfahren zum Herstellen eines Supraleiter vom Typ selten Erde-Barium-Kupraten
Procédé de fabrication d'un supraconducteur de type cuprates de barium et terres rares

(30) Priority: 21.03.1997 US 42332 P
(43) Date of publication of application: 23.09.1998
(73) Proprietor: Haldor Topsoe A/S, 2800 Lyngby (DK)
(72) Inventor: Christiansen, Jens, 2800 Lyngby (DK)
(74) Representative: Zimmer, Franz-Josef, Dr.

(56) References cited:
- EP-A- 0 358 049
- EP-A- 0 495 677
- WO-A-96/21934

## Description

The present invention relates to a method of preparing rare earth-barium-cuprates superconductors by melt texturing of the superconducting material on a metallic substrate.

Melt texturing of yttrium rare earth-barium-cuprates superconducting material on silver substrate has earlier been prohibited in air by the high melting point of the material in air exceeding the melting point of silver in air.

The method of this invention is based on changes of the melting point (peritectic decomposition temperature) of the rare earth-barium-cuprate superconductors (RE123, RE = Y, La, Nd, Sm, Eu, Gd, Dy, Ho, Er, Tm, Yb, Lu), as well as the non-superconducting Pr123 phase and the melting point of silver as a function of the partial oxygen pressure (p(O₂)). It has previously been demonstrated that the melting point of the RE_{1+y} Ba_{2-y} Cu₃O₇₋ₓ, (0 ≤ y ≤ 0.9, 0 ≤ x ≤ 1) conventionally designed RE123 decreases as p(O₂) is reduced. Further, it is well known that the melting point of silver increases as p(O₂) is reduced. Thus, it is possible to melt several RE123 phases below the melting point of silver at low p(O₂).

According to this invention, a highly textured microstructure of the RE123 material is obtained by a sequence of steps, comprising a first step having a mixture of aligned high-m.p. RE123 (RE=Nd, La, Sm, Eu, Gd, Tb, Dy, Ho) platelets with a high melting temperature and RE123 powder with a low melting temperature RE=Y, Er, Tm, Yb, Lu. Then in a second step, heating to a temperature between above the melting point of the low-m.p. RE123 and below the melting point of silver, and in a third step nucleation and epitaxial growth of the low-m.p. RE123 phase on the platelets during cooling. Using the present heat treatment in low p(O₂)-atmosphere, RE123/silver wires and tapes, with a highly aligned RE123 material are produced using conventional "powder in tube" and "thick film" technologies.

Tapes may also be prepared using other metallic substrates such as nickel tapes coated with an inert buffer layer known in the art, including silver, barium zirconate magnesium oxide and RE₂ BaCuO₅.

### Example

Y123 powder is dry mixed with Nd123 platelets, both phases with a low chemical bound oxygen content in each phase e.g. REBa₂Cu₃O_{6+Y} (Y = 0-0.5) and poured into a silver tube. After evacuation and sealing of the tube, it is drawn and/or rolled several times and finally pressed into a thin tape. The tape is heated to 870-970°C at p(O₂) = 10⁻⁵-10⁻² bar, then cooled to below the melting point of Y123 at 0.1-10 K/h. The tape is finally annealed at 400-800°C in pure oxygen.

## Claims

1. Method of preparing a rare earth-barium-cuprate superconductor in form of a thick film on metallic tapes, metallic wires, or as powder in a tube comprising steps of supporting on a metallic substrate a mixture of seed crystals of rare earth-barium-cuprate with a high melting point and rare earth-barium-cuprate powder with a lower melting point;
subjecting the supported material on the substrate to heat treatment at a temperature below the melting point of the high melting rare earth-barium-cuprate seed crystals and the metallic substrate and above the melting point of the low melting powder; and
cooling the heat treated supported material below the melting temperature of the material.

2. The method of claim 1, wherein the rare earth-barium-cuprate material comprises oxides of Y, La, Nd, Sm, Eu, Gd, Dy, Ho, Er, Tm, Yb, Lu, Pr and mixtures thereof.

3. The method of claim 1, wherein the metallic substrate is silver.

4. The method of claim 1, wherein the metallic substrate is nickel and/or stainless steel provided with an inert buffer layer.

## Patentansprüche

1. Verfahren zur Herstellung eines Seltenerd-Barium-Kuprat-Supraleiters in Form eines dicken Filmes auf Metallbändern, Metalldrähten oder als Pulver in einem Rohr, umfassend die Schritte des Aufbringens einer Mischung von Impfkristallen von Seltenerd-Barium-Kuprat mit einem hohen Schmelzpunkt und Seltenerd-Barium-Kuprat-Pulver mit einem niedrigeren Schmelzpunkt auf ein Metallsubstrat;
des Wärmebehandeins des auf dem Substrat aufgebrachten Materials bei einer Temperatur unterhalb des Schmelzpunkts der hoch schmelzenden Seltenerd-Barium-Kuprat-Impfkristalle und des Metallsubstrats und oberhalb des Schmelzpunkts des niedrig schmelzenden Pulvers; und
Abkühlen des aufgebrachten, wärmebehandelten Materials unter die Schmelztemperatur des Materials.

2. Verfahren nach Anspruch 1, worin das Seltenerd-Barium-Kuprat-Material Oxide von Y, La, Nd, Sm, Eu, Gd, Dy, Ho, Er, Tm, Yb, Lu, Pr und Mischungen davon umfasst.

3. Verfahren nach Anspruch 1, worin das Metallsubstrat Silber ist.

4. Verfahren nach Anspruch 1, worin das Metallsubstrat Nickel und/oder mit einer inerten Pufferschicht versehener nichtrostender Stahl ist.

## Revendications

1. Procédé pour préparer un supraconducteur de type cuprate-baryum-terre rare sous forme d'un film épais sur des bandes métalliques, des fils métalliques, ou sous forme de poudre dans un tube comprenant les étapes consistant à :
- supporter, sur un substrat métallique, un mélange de germes cristallins de type cuprate-baryum-terre rare ayant un point de fusion élevé et une poudre de type cuprate-baryum-terre rare ayant un point de fusion inférieur ;
- soumettre le matériau supporté sur le substrat à un traitement thermique à une température inférieure au point de fusion des germes cristallins de type cuprate-baryum-terre rare ayant un point de fusion élevé et du substrat métallique, et supérieure au point de fusion de la poudre ayant un point de fusion inférieur ; et
- refroidir le matériau supporté traité thermiquement au-dessous de la température de fusion du matériau.

2. Procédé selon la revendication 1, dans lequel le matériau de type cuprate-baryum-terre rare comprend des oxydes de Y, La, Nd, Sm, Eu, Gd, Dy, Ho, Er, Tm, Yb, Lu, Pr et leurs mélanges.

3. Procédé selon la revendication 1, dans lequel le substrat métallique est l'argent.

4. Procédé selon la revendication 1, dans lequel le substrat métallique est le nickel et/ou l'acier inoxydable pourvu d'une couche tampon inerte.
